# EUROPÄISCHE PATENTSCHRIFT

(11) **EP 0 769 702 B1**
(45) Veröffentlichungstag und Bekanntmachung des Hinweises auf die Patenterteilung: **21.04.1999**
(21) Anmeldenummer: 96115778.1
(22) Anmeldetag: 02.10.1996
(51) Int. Cl.: G01R 19/145

(54) **Prüfgerät mit einem Anzeigeelement**
Inspection device with display
Dispositif de contrôle avec afficheur

(30) Priorität: 21.10.1995 DE 19539227
(43) Veröffentlichungstag der Anmeldung: 23.04.1997
(73) Patentinhaber: AEG Sachsenwerk GmbH, D-93055 Regensburg (DE)
(72) Erfinder: Stegmüller, Karl, Dipl.-Ing., 93109 Wiesent (DE)
(74) Vertreter: Dreiss, Fuhlendorf, Steimle & Becker

(56) Entgegenhaltungen:
- DE-A- 3 219 703
- DE-A- 4 323 731

## Beschreibung

Die Erfindung betrifft ein Prüfgerät gemäß dem Oberbegriff des ersten Anspruchs.

Ein bekanntes Prüfgerät dieser Art (DE 43 23 731 A1) dient zur Anzeige des Vorhandenseins oder Fehlens der elektrischen Spannung in Hoch- oder Mittelspannungsanlagen. Es weist ein Koppelteil auf, das über eine Koppelelektrode kapazitiv an einen hochspannungsführenden Bauteil angekoppelt und für die Speisung eines Anzeigeelements ausgebildet ist. Zur Überprüfung der Funktionstauglichkeit des Koppelteils weist das Prüfgerät einen zusätzlichen Meßpfad auf, der bei einem vorbestimmten Mindestprüfwert ein zusätzliches Steuersignal erzeugt, das im mehrfeldigen Anzeigeelement ein Fehlersignal generiert. Das Anzeigeelement ist dabei zickzackförmig nach Art eines Blitzes als Hinweis auf Hochspannung geformt und weist in einem Schenkelabschnitt ein getrennt steuerbares Teilanzeigefeld in Form eines Werkzeugs auf. Von Nachteil ist bei dieser Ausgestaltung des Anzeigeelements, daß bei einer kleinen Ausgestaltung des Anzeigefeldes das als Warnhinweis dienende Teilanzeigefeld nicht klar in Erscheinung tritt.

Aufgabe der Erfindung ist es, bei einem Prüfgerät gemäß dem Oberbegriff des ersten Anspruchs Maßnahmen zu treffen, durch welche eine eindeutige Abgrenzung einzelner Teilanzeigefelder erreicht wird.

Die Lösung dieser Aufgabe folgt gemäß der Erfindung durch die kennzeichnenden Merkmale des ersten Anspruchs.

Bei einer Ausgestaltung eines Prüfgeräts gemäß der Erfindung wird das Anzeigefeld aus wenigstens drei aufeinanderfolgenden Teilanzeigefeldern aufgebaut, wobei die einzelnen aufeinanderfolgenden Teilanzeigefelder zumindest abwechselnd an unterschiedliche Steuerleitungen angeschlossen sind, so daß beim Ausfall eines Steuersignals das Gesamt-Anzeigefeld optisch geteilt wird. Für den Benutzer des Prüfgeräts ergibt sich daraus ein Hinweis auf einen Fehlerzustand am Prüfgerät oder der zugehörigen Kopplung mit dem zu prüfenden hochspannungsführenden Bauteil. Insbesondere ist das Anzeigefeld des Anzeigeelements aus einem LCD-Element gebildet, das aufgrund seines geringen Steuerleistungsbedarfs ohne fremde Spannungsquelle direkt aus der kapazitiven Kopplungseinrichtung nach entsprechender Umrichtung gespeist werden kann.

Die Erfindung ist nachfolgend anhand der Skizze eines Ausführungsbeispiels näher erläutert.

Ein Prüfgerät zum Feststellen des Vorhandenseins oder Fehlens der elektrischen Spannung, besonders in Mittelspannungs-Schaltanlagen, wird an ein nicht dargestelltes vorschriftsmäßiges Koppelteil angeschlossen, das nach festgelegten Kriterien mit einem spannungsführenden Bauteil kapazitiv gekoppelt wird. Die über das Koppelteil ausgekoppelte elektrische Leistung wird einem Anpassungsglied 1 an seinen Eingangsanschlüssen 2 und 3 zugeführt, wobei das Anpassungsglied als kapazitives Widerstands-Transformationsglied ausgebildet ist. An dem Ausgang des Anpassungsglieds ist ein vorzugsweise in Brückenschaltung betriebenes Gleichrichterelement 4 angeschlossen, dessen Gleichstromausgang zwei elektrisch parallel geschaltete Meßpfade I und II speist. Die Eingangsbauelemente 5 bzw. 6 der beiden Meßpfade sind als Spannungspegel-Erkennungsschaltungen ausgebildet, die insbesondere nach Art von Schwellwertschaltern oder Schmidt-Triggern aufgebaut sind und abhängig vom Eingangspegel entweder ein Einschaltsignal oder ein Ausschaltsignal erzeugen. Den Spannungspegel-Erkennungsschaltungen 5, 6 ist jeweils eine Ansteuerschaltung 7, 8 nachgeschaltet, die zur Ansteuerung von Feldgrupen in einem mehrfeldigen LCD-Anzeigeelements 9 dienen. Die Schaltpegel der Spannungspegel-Erkennungsschaltungen sind so ausgelegt, daß bei einem noch auf ordnungsgemäße Funktion schließen lassenden Spannungspegel der Meßpfad I ein Einschaltsignal generiert, während der Meßpfad II bei einem um einen Sicherheitsfaktor höheren Spannungspegel ebenfalls noch ein Einschaltsignal erzeugt. Ist der für den zweiten Meßpfad vorgegebene Mindestspannungspegel vorhanden, erzeugen beide Meßpfade ein Einschaltsignal. Wird dieser für den Meßpfad II vorgegebene Mindestspannungspegel unterschritten, generiert der Meßpfad II kein Ausgangssignal, jedoch steht am Meßpfad I ein Ausgangssignal an, wenn dessen untere Ansprechspannung nicht unterschritten ist.

Das Anzeigeelement 9 ist mit einem aktivierbaren blitz- oder zickzackförmig gestalteten Gesamt-Anzeigefeld 10 ausgestattet, das sich aus getrennt ansteuerbaren, in Längsrichtung aufeinanderfolgenden Teilanzeigefeldern 10.1 bzw. 10.2 zusammensetzt. Die Felder 10.1 sind demnach jeweils durch die Felder 10.2 vollkommen voneinander getrennt. Dies trifft analog auch auf die Felder 10.2 zu, die jeweils durch ein Feld 10.1 voneinander beabstandet sind. Dabei sind die Teilanzeigefelder 10.1 parallel geschaltet und an den Ausgang der Ansteuerschaltung 7 des ersten Meßpfades I angeschlossen, während die Teilanzeigefelder 10.2 untereinander parallel und gemeinsam an den Ausgang der Ansteuerschaltung 8 des Meßpfades II angeschlossen sind.

Wenn die nicht dargestellte Koppelschaltung ein Signal in einer solchen Höhe liefert, wie es bei ordnungsgemäßer Funktion des Koppelteils aus der hochspannungsführenden Leitung ausgekoppelt wird, dann erzeugen beide Spannungspegel-Erkennungsschaltungen 5, 6 ein Einschaltsignal, so daß über die zugehörigen Ansteuerschaltungen 7 und 8 bzw über deren Ausgangsgruppen-Steuerleitungn 7.1 bzw 8.1 die Teilanzeigefelder 10.1 und 10.2 aktiviert werden. Hierdurch wird das Gesamtanzeigefeld 10 als einheitliche Anzeigefläche aktiviert. Wenn dagegen der vom Koppelteil ausgekoppelte Spannungspegel den Ansprechwert der Spannungspegel-Erkennungsschaltung 6 des Meßpfades II, nicht jedoch den Ansprechwert der Spannungspegel-Erkennungsschaltung 5 des Meßpfades I unterschreitet, dann werden die Teilanzeigefelder 10.2 nicht mehr aktiviert, so daß nur die Teilanzeigefelder 10.1 angesteuert sind und ein Fehlersignal generieren, weil dann die Zeitlinie des Anzeigefeldes 10 unterbrochen ist. In diesem Falle ist auf eine Fehlfunktion des Koppelgliedes zu schließen. Es bleibt aber dadurch der Hinweis erhalten, daß am zu überwachenden Hochspannungsbauteil noch immer Hochspannung anliegt. Die Unterbrechung des als Pfeilfeld ausgebildeten Anzeigefeldes durch Teilung des Gesamtanzeigefeldes in Längsrichtung in mehrere Teilanzeigefelder bewirkt durch die Ansteuerung nur jedes zweiten Teilanzeigefeldes im Fehlerfalle ein eindeutiges Fehlersignal. Die Teilanzeigefelder 10.1 bzw. 10.2 heben sich zumindest im aktivierten Zustand vom Erscheinungsbild der umgebenden Fläche des Anzeigeelements 9 ab.

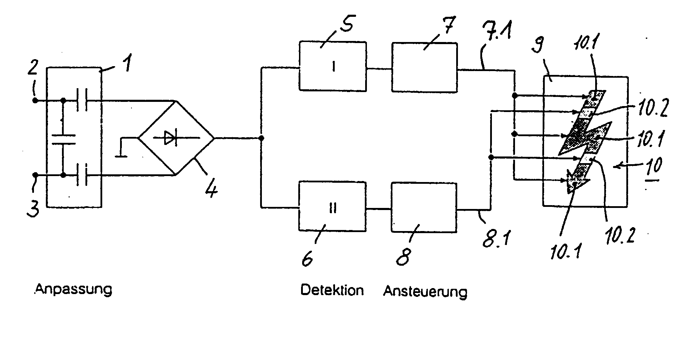

## Patentansprüche

1. Prüfgerät mit zwei Steuerleitungen (7.1, 8.1) und mit einem Anzeigeelement (9), das ein Anzeigefeld (10) aufweist, das mit zwei elektrisch getrennt ansteuerbaren Teilanzeigefeldern (10.1, 10.2) versehen ist, die an jeweils eine der beiden Steuerleitungen (7.1, 8.1) angeschlossen sind, **dadurch gekennzeichnet,** dass die beiden Teilanzeigefelder (10.1, 10.2) und ein drittes Teilanzeigefeld (10.1) in Längsrichtung aufeinanderfolgend angeordnet sind, und dass aneinander angrenzende Teilanzeigefelder (10.1, 10.2, 10.1) an jeweils eine andere der beiden Steuerleitungen (7.1, 8.1) angeschlossen sind.

2. Prüfgerät nach Anspruch 1, dadurch gekennzeichnet, dass das Anzeigelement (9) ein LCD-Element ist.

3. Prüfgerät nach Anspruch 1 oder 2, dadurch gekennzeichnet, dass das Anzeigefeld (10) in Längsrichtung zickzack- oder pfeilförmig verlaufend ausgebildet ist.

## Claims

1. Test device having two control lines (7.1, 8.1) and a display element (9) which has a display panel (10) provided with two electrically separately actuable display panel portions (10.1, 10.2) which are each connected to a respective one of the two control lines (7.1, 8.1), characterised in that the two display panel portions (10.1, 10.2) and a third display panel portion (10.1) are arranged in succession in the longitudinal direction and that mutually adjoining display panel portions (10.1, 10.2, 10.1) are connected to a respective other one of the two control lines (7.1, 8.1).

2. Test device according to claim 1 characterised in that the display element (9) is an LCD-element.

3. Test device according to claim 1 or claim 2 characterised in that the display panel (10) is of a configuration extending in a zigzag or arrow-shaped configuration in the longitudinal direction.

## Revendications

1. Appareil de contrôle comportant deux lignes de commande (7.1, 8.1) et un élément d'affichage (9) qui comporte une zone d'affichage (10) qui est pourvue de deux zones d'affichage partielles (10.1, 10.2) commandables séparées électriquement qui sont raccordées chacune à une des deux lignes de commande (7.1, 8.1), caractérisé en ce que les deux zones d'affichage partielles (10.1, 10.2) et une troisième zone d'affichage partielle (10.1) sont disposées en se succédant l'une après l'autre selon la direction longitudinale et en ce que des zones d'affichage partielles (10.1, 10.2, 10.1) en contact l'une avec l'autre sont raccordées à chaque fois avec l'autre des deux lignes de commande (7.1, 8.1).

2. Appareil de contrôle selon la revendication 1, caractérisé en ce que l'élément d'affichage est un élément à cristaux liquides (9).

3. Appareil de contrôle selon la revendication 1 ou 2, caractérisé en ce que la zone d'affichage (10) est réalisée, selon la direction longitudinale, sous la forme d'un zigzag ou d'une flèche.
